# EUROPEAN PATENT SPECIFICATION

(11) **EP 1 274 581 B1**
(45) Date of publication and mention of the grant of the patent: **07.07.2004**
(21) Application number: 01921256.2
(22) Date of filing: 11.04.2001
(51) Int. Cl.: B41C 1/05, H01S 3/10

(54) **A METHOD AND AN APPARATUS FOR CONTROLLING LIGHT INTENSITY IN CONNECTION WITH THE EXPOSURE OF PHOTOSENSITIVE MATERIAL**
VERFAHREN UND VORRICHTUNG ZUR STEUERUNG DER LICHTINTENSITÄT IN VERBINDUNG MIT DER BELICHTUNG VON LICHTEMPFINDLICHEM MATERIAL
PROCEDE ET DISPOSITIF DE COMMANDE DE L'INTENSITE LUMINEUSE EN RAPPORT AVEC L'EXPOSITION D'UN MATERIAU PHOTOSENSIBLE

(30) Priority: 12.04.2000 DK 200000614
(43) Date of publication of application: 15.01.2003
(73) Proprietor: Esko-Graphics A/S, 2750 Ballerup (DK)
(72) Inventor: RAUNKJAER, Michael, DK-2765 Smoerum (DK); BENGTSON, Bo, DK-8464 Galten (DK)
(74) Representative: Boesen, Johnny Peder
(86) International application number: PCT/DK2001/000260
(87) International publication number: WO 2001/076872

(56) References cited:
- EP-A1- 0 989 736

## Description

This invention relates to a method of controlling light intensity in connection with the exposure of photosensitive material in an imagesetter/platesetter comprising a light source for illuminating said photosensitive material.

The invention moreover relates to an apparatus for controlling light intensity in connection with the exposure of photosensitive material in an imagesetter/platesetter comprising a light source for illuminating said photosensitive material.

More specifically, this invention relates to embodiments of an apparatus and of a method in connection with the exposure of photosensitive materials/media, such as e.g. films and/or sheets of e.g. polyester, paper, etc. for the printing of printed matter and the like, in an image-setter/platesetter.

As an example in this specification, the illuminated portions become black/dark, but the medium may also be of a type where the unilluminated portions become black/dark. A distinction is made between positive and negative media. Here, as an example, the exposure is negative, whereby the medium is positive.

Inter alia a laser and optical components are typically used for the exposure of the photosensitive media. Known are both expensive and high-resolution solutions where the laser has a relatively small spot size, and use is made of complicated optical components as well as less expensive components where a less focussed laser and/or less complicated optical components are employed, which gives a relatively larger spot size.

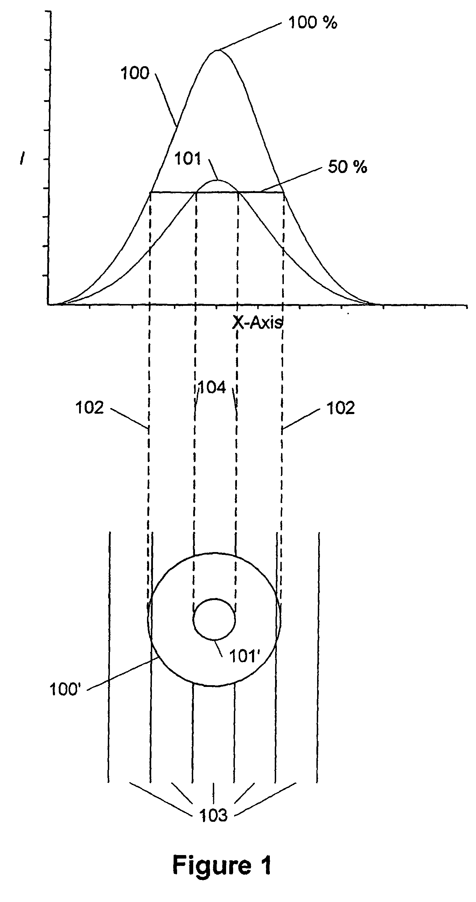

The light intensity of a laser has a gauss distribution (normal distribution), and the spot size is typically defined as the degree of the intensity at a 50% level (see Figure 1).

A known method of improving the resolution by reducing the spot size of the laser in an imagesetter/platesetter is to use a lower power, as explained more fully and indicated in connection with Figure 1.

In addition, a Raster Image Processor (RIP) is frequently used in connection with imagesetters/platesetters for an initial data processing, where a standard data file containing image information, such as e.g. a postscript (PS) file, is processed prior to transmission to the imagesetter/platesetter itself, which receives the processed information and exposes films, printing plates in accordance therewith.

An important parameter for printing, in addition to resolution, quality, etc., is also constancy of the printed copies manufactured on the basis of a printing plate. This means that the copies printed last and the copies printed first must be as uniform as possible.

An extremely relevant problem in connection with the constancy is a phenomenon which is typically called spot wear.

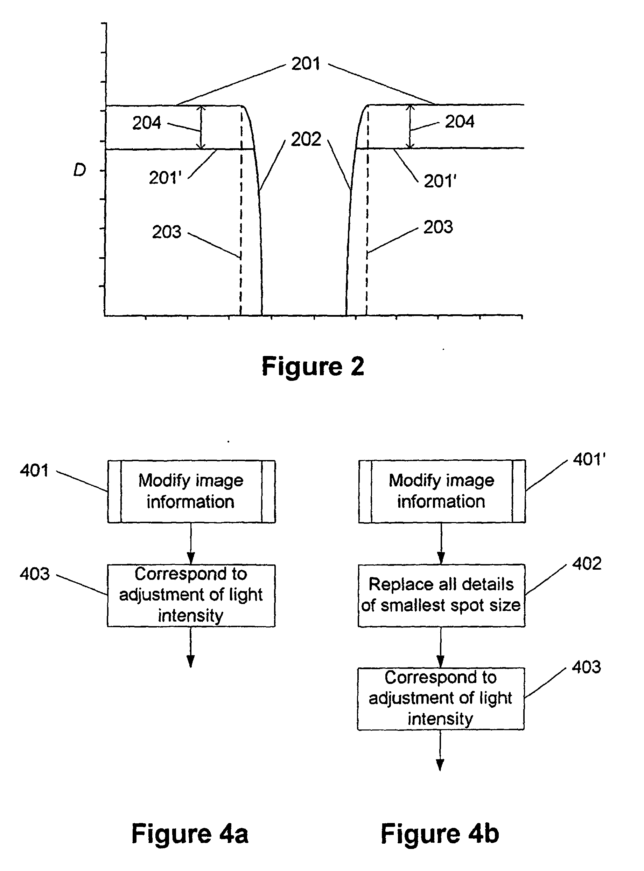

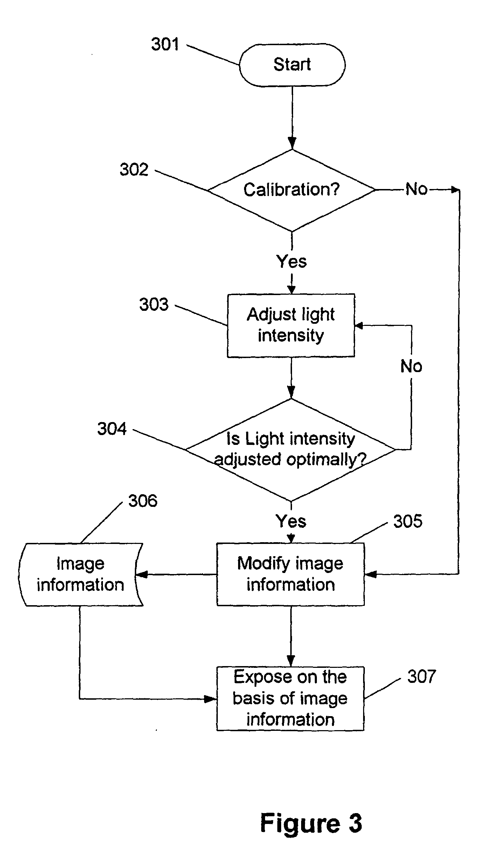

Spot wear causes non-uniformity from the first to the last prints with a plate. The spot wear takes place because the transition between exposed and non-exposed material on the printing plate does not happen approximately discontinuously, but there is a pronounced softer transition (cf. Figure 2).

The spot wear also causes fine details to be blurred and/or to disappear completely. In particular for details in inverse, small types with feet, etc.

The spot wear also causes fogging of the printed copy, blurring of lines, and an increased amount of black on the later copies made on the basis of a given printing plate.

The spot wear is extremely relevant particularly in connection with lasers having a relatively large spot size, as the power of the laser is typically turned down in order to achieve a resolution as great as possible, as mentioned above.

An object of the invention is to provide a method which avoids/reduces the effect of spot wear.

This is achieved by using a relatively great/greater power/light intensity relatively to previously known methods, where the power was typically reduced in order to provide a higher resolution. With a correct amount of light, the light distribution around the photographic threshold will moreover increase as much as possible, which results in a maximum steep transition between exposed and non-exposed material.

A relatively greater power, however, causes a new problem, since a greater power will increase the amount of exposed material, i.e. will "spread the black lines" because of the increased spot size. The greater the power, the greater the increase of exposed material. The increase of exposed material is identifiable at the edges of an area which is to be exposed.

A solution to this problem is to correct the image information itself, optionally in the data file, for the images which are to be processed and/or on the basis of which printing plates are to be made. This is done by reducing the time during which the light source is active in such a manner that the amount of exposed material is not increased after exposure in spite of the, other things being equal, greater light intensity/power which spreads exposed areas.

This may be e.g. accomplished in that the light source is turned on and off earlier to compensate a greater extent of the spot size of the light source because of increasing power.

This is done e.g. by scanning the data file and reducing the exposed areas ("black areas") by a factor corresponding to the factor by which the power increase spreads the exposed material, so that these factors neutralize each other during the exposure/manufacture of the subsequent printing plates.

More specifically, the object of the invention is achieved by a method of the type mentioned initially, wherein
- the light intensity of said light source is increased to a predetermined level ensuring a sufficiently steep transition between exposed and non-exposed material, and
- image information representing material for exposure is modified so as to reduce the time during which the light source is active.

This provides a method where the effect of spot wear is minimized/eliminated, as the transitions between exposed and non-exposed material are as steep as possible, without the amount of the exposed material being increased, as the correction in the data file ensures that the contributions neutralize each other.

In a preferred embodiment, defined in claim 2, said adjustment of said light intensity is provided by
- selecting an ideal test pattern and an associated corrected test pattern,
- storing image information representing the corrected test pattern, and
- adjusting the light intensity so that exposure of the corrected test pattern provides an image of the ideal uncorrected test pattern.

This provides a simple way of determining/adjusting the optimum light intensity, so that the spot wear is minimized and/or completely avoided for the subsequent exposure(s).

This adjustment/calibration of the light intensity may advantageously be performed as needed, since the parameters for electrical components are changed in dependence on e.g. ageing, temperature, etc. Typically, an adjustment will be made once a day.

The adjustment might e.g. by made by using the corrected test pattern for exposing a printing plate, film, etc. and adjusting the light intensity until the produced printing plate is uniform with the ideal test pattern. This comparison might take place e.g. manually using a microscope.

In an embodiment, defined in claim 3, said adjustment is provided automatically. Hereby an imagesetter may be calibrated by a simple pressure on a button, switch, etc. Such an automatic adjustment might be provided e.g. by inputting image information for the ideal test pattern and comparing it with scanned image information for the corrected test pattern (which varies in dependence on the light intensity), and then adjusting the light intensity until the two test patterns were identical or at least within a suitably selected tolerance value. The adjustment of the light intensity may also be made automatically under control of suitable control electronics or the like.

In a preferred embodiment, defined in claim 4, said ideal test pattern comprises a first part comprising a sequence of non-exposed, exposed and non-exposed areas in a given direction as well as an adjacent second part comprising a sequence of exposed, non-exposed and exposed areas in said direction, wherein the central exposed area associated with the first part and the central non-exposed area associated with the second part have the same extent in said direction and are positioned adjacently.

Preferably, the central exposed area associated with the first part (and thereby the central non-exposed area associated with the second part) has the same extent as the spot size of the laser used.

In an embodiment, defined in claim 5, said corrected test pattern comprises a first part comprising a sequence of non-exposed, exposed and non-exposed areas in one direction as well as an adjacent second part comprising a sequence of exposed, non-exposed and exposed areas in said direction, wherein the central exposed area associated with the first part has a smaller extent in said direction than the central non-exposed area associated with the second part, and wherein the central non-exposed area associated with the second part is positioned adjacently and symmetrically at the central exposed area associated with the first part.

This provides a simple way of adjusting the correct and optimum power/light intensity using a suitably selected test pattern. The specific configuration and extent of the test pattern generally depend on a number of parameters such as e.g. spot size, plate material, resolution, etc.

In an embodiment, defined in claim 6, the exposed area associated with the sequence of the first part of said corrected test pattern is 4 scan lines wide, and the non-exposed area associated with the sequence of the second part of said corrected test pattern is 6 scan lines wide.

If, as stated in claim 7, the flank steepnesses of the light intensity at the transitions of the first part and the second part, respectively, are maximum at the threshold level of the photographic medium for exposed/non-exposed, then a clear/an as-optimum-as-possible transition is achieved between materials which are to be exposed and non-exposed, respectively.

Preferably, peaks of the light intensity of the first part and the second part, respectively, must be as uniform as possible.

In an embodiment, the threshold level of light intensity defining exposed is essentially 3.3 times greater than the threshold level of light intensity defining non-exposed according to the Gradation curve, also known as the Hurter-Driffield curve (H-D curve).

This factor of about 3.3, however, depends on the plate material used for exposure.

As stated in claim 8, said modification of image information comprises a change in the data file which defines an original prior to the exposure/further processing/copying of it. This modification (including analysis of the date file) may advantageously be performed in the RIP.

In a preferred embodiment, defined in claim 9, said modification comprises a modification such that all information in the data file at least has a spread of the same extent as the spot size of said light source.

This means that the data file is corrected so that all details (both exposed and non-exposed (black/white)) at least have a spread of the spot size, since, anyhow, it is not possible to produce smaller details than the spread of the spot size for a given light source.

Preferably, said light source is a laser diode. This allows a very inexpensive construction of the imagesetter, as the relatively large spot size for such a light source does not impair the quality of the printed copies considerably when the spot wear has been handled.

Another object of the invention is to provide an apparatus which has the same advantages as the above method for the same reasons.

This is achieved by an apparatus of the type stated initially, which apparatus additionally comprises adjustment means for adjusting the light intensity so that the light intensity of said light source may be increased to a predetermined level ensuring a steep transition between exposed and non-exposed material, a storage comprising image information representing material for exposure, and a processing unit modifying the image information so as to reduce the time during which the light source is active.

Some embodiments of the apparatus will be described below, which correspond to embodiments of the method and have corresponding advantages.

In an embodiment of the apparatus according to claim 11, said adjustment of said light intensity is provided in that
- an ideal test pattern and an associated corrected test pattern are selected,
- image information representing the corrected test pattern is stored, and
- the light intensity is adjusted so that exposure of the corrected test pattern provides an image of the ideal uncorrected test pattern.

Said adjustment may be provided automatically, as stated in claim 12.

In a preferred embodiment, defined in claim 13, said ideal test pattern comprises a first part comprising a sequence of non-exposed, exposed and non-exposed areas in a given direction as well as an adjacent second part comprising a sequence of exposed, non-exposed and exposed areas in said direction, wherein the central exposed area associated with the first part and the central non-exposed area associated with the second part have the same extent in said direction and are positioned adjacently.

In a preferred embodiment, defined in claim 14, said corrected test pattern comprises a first part comprising a sequence of non-exposed, exposed and non-exposed areas in one direction as well as an adjacent second part comprising a sequence of exposed, non-exposed and exposed areas in said direction, wherein the central exposed area associated with the first part has a smaller extent in said direction than the central non-exposed area associated with the second part, and wherein the central non-exposed area associated with the second part is positioned adjacently and symmetrically at the central exposed area associated with the first part.

In a preferred embodiment, defined in claim 15, the exposed area associated with the sequence of the first part of said corrected test pattern is 4 scan lines wide, and the non-exposed area associated with the sequence of the second part of said corrected test pattern is 6 scan lines wide.

In a preferred embodiment, defined in claim 16, the flank steepnesses of the light intensity at the transitions of the first part and the second part, respectively, are maximum at the threshold level of the photographic medium for exposed/non-exposed.

In a preferred embodiment, defined in claim 17, said modification of image information comprises a change in the data file which defines an original prior to the further processing/copying/exposure of it.

As stated in claim 18, said modification comprises a modification/adjustment so that all information in the data file at least has a spread of the same extent as the spot size of said light source.

Preferably, said light source is a laser diode.

Alternatively, the light source may be all types of light sources having a Gaussian light distribution.

The invention will be explained more fully below with reference to the drawing, in which
Figure 1 illustrates a graph of the light intensity of an unadjusted light source and a down-adjusted light source, respectively, as well as the associated spot size;
Figure 2 illustrates the phenomenon spot wear;
Figure 3 shows a flowchart for a preferred embodiment of the method;
Figures 4a and b illustrate alternative embodiments of a method according to the invention for modifying image information;
Figure 5 illustrates the stepwise change of a detail in accordance with an embodiment according to the invention;
Figure 6a shows an uncorrected test pattern and a corrected test pattern, respectively, according to a preferred embodiment according to the invention;
Figure 6b illustrates the H-D curve;
Figures 7a, b and c show examples of how various test patterns may be evaluated;
Figure 8 shows a schematic block diagram of an embodiment of an apparatus according to the invention.

Figure 1 illustrates a graph of the light intensity of an unadjusted light source and of a down-adjusted light source, respectively, as well as the associated spot size. Also shown is the relationship between power and spot sizes. The figure shows two curve shapes (100, 101) for the intensity (I) as a function of the spreading from the centre of a light source at two different powers.

One curve (100) is for a given laser light source and is a Gaussian curve (normal distribution curve), where a level at 50% of the total power is also indicated. The spread, i.e. the diameter of the light source, at this 50% level defines the spot size. The spot size is a measure of the smallest dot/the smallest area which the laser/light source can plot. The associated spot size (100') for the curve (100) is indicated at the bottom of the figure by following the two lines (102), which illustratively indicate the relationship between the two graphs. Also indicated are 5 exemplary scan lines (103) for comparison. A scan line consists of adjacent pixels/image addressing points (not shown). Scan lines are positioned side by side/adjacently, e.g. so that the centre distance between two adjacent pixels is equal to the centre distance between two adjacent scan lines.

It will be seen that in this example the spot size (100') cannot address a single scan line (103), and the given light source will therefore not be able e.g. to expose details of the order of a single scan line. Relatively large spot sizes are typically common in devices having less complicated and thereby typically cheaper optical components and laser source.

In the prior art, the power is frequently turned down to achieve a greater resolution (i.e. smaller spot size). The curve (101) shows such an example where the power is turned down relatively to the curve (100), so that the peak is slightly above the photographic threshold level. This gives a smaller spot size (101'), as indicated by following the lines (104). Such a smaller spot size (101') ensures that the resolution is improved at the expense of a low exposure light intensity, which, however, is usually too low to give a correct/useful exposure, as will be explained below.

Generally, a problem arises if films, printing plates, etc. are made/exposed using a too low power, since the transitions between exposed and non-exposed material does not take place abruptly/discontinuously. The lower the power is relative to an optimum adjustment, the softer the transition will be between exposed and non-exposed material. This problem is aggravated additionally if the power is turned down to increase the resolution.

It is these soft transitions that cause spot wear, which will be explained more fully in connection with Figure 2.

Figure 2 illustrates the phenomenon spot wear. The figure schematically shows a curve (201) of the density D (i.e. the colour density of the exposed material) for a section of an exposed printing plate containing areas which are exposed, non-exposed and exposed, respectively, in the direction of the x-axis.

It will be seen that the transition between exposed and non-exposed material follows a soft curve (202) and not the ideal discontinuous/abrupt transition indicated by the dashed lines (203) in the figure. The reason for the soft transition (202) is that the printing plate has not been exposed with a sufficiently great power.

When a plate with such a soft transition (202) is used for making printed matter, the uppermost material on the plate will gradually be worn deeper and deeper. This is illustrated in the figure by the double arrows (204) and will have a density for exposed area indicated by the lines (201').

In the worn state (201'), the soft transition (202) will mean that a larger area will smear the printed matter, and the black/dark edges will therefore be blurred, causing a loss of details on the printed matter produced subsequently. The more the printing plate is worn, the more spread/blurred the exposed areas will be.

Spot wear can be observed in practice e.g. by using a so-called 50% screen which consists of material that is to be exposed and non-exposed in a chequered pattern. The proportion of material to be exposed and non-exposed, respectively, is 50%, as indicated by the name. If a printing plate is developed/exposed on the basis of such a 50% screen, the density of the copies made may be measured in a suitable manner, and it will be observed that the density will increase in use perhaps to 60% - 70%.

The spot wear also causes problems such as e.g. that fine (non-exposed) details disappear because of the spreading of the exposed areas. For example, fine details in inverse text will frequently disappear completely.

Figure 3 shows a flowchart for a preferred embodiment of the method. The method is initiated in step (301). In step (302) it is tested whether calibration/adjustment of the light intensity of the light source is desired/necessary. This may e.g. be the case before each commenced working day when a calibration is needed, or at other intervals/times in order to optimize the exposure process.

The need for calibration/adjustment may also be indicated automatically in dependence on one or more criteria, such as e.g. by scanning and comparing an early/first and a later/last copy and determining the difference, whereby e.g. the effect of the spot wear can be identified.

The indication might be given manually e.g. by an operator or the like by simple pressure on a button.

If calibration is not necessary, the method proceeds to step (305), which will be described later. If the test results in "yes" (true), step (303) is performed, where the light intensity is adjusted.

It is tested in step (304) whether the light intensity has been adjusted correctly/optimally, and if this is not the case, step (305) is performed once more, where the light intensity is adjusted additionally.

This iterative process (steps (303) and (304)) may be performed iteratively either automatically or manually until e.g. one or more given parameters have been fulfilled.

Automatically, e.g. by scanning and comparing an early/first and a later/last copy, cf. the foregoing.

Manually, in that an operator could compare copies e.g. through a microscope or the like.

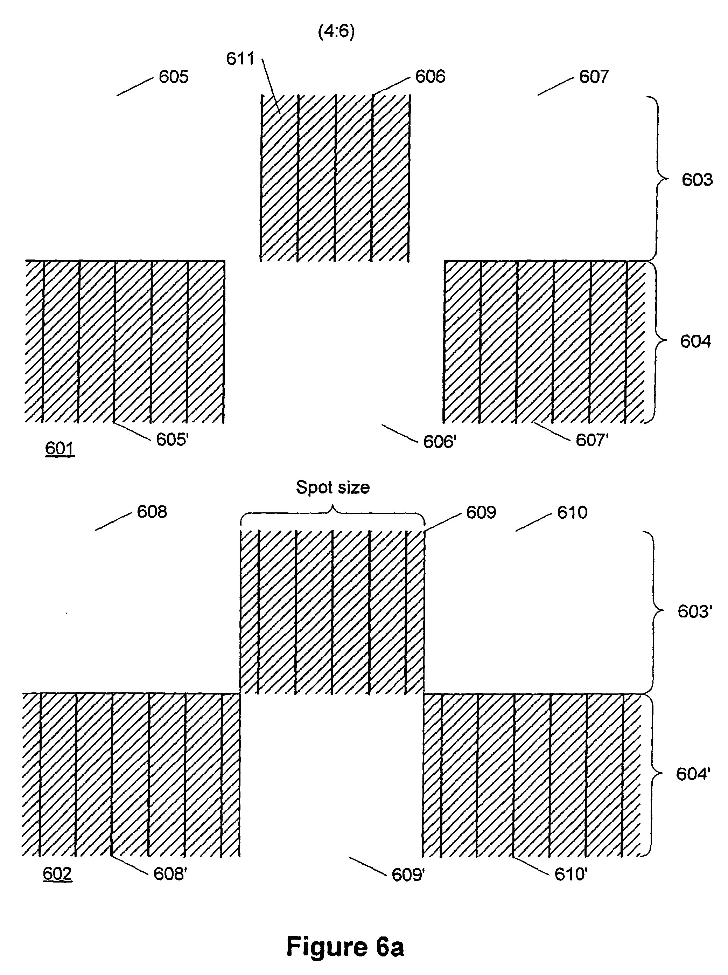

Preferably, a suitably selected test pattern is used for calibrating/adjusting the light intensity correctly, as will be explained in connection with Figure 6a.

When the condition in step (304) has been fulfilled, the method proceeds to step (305), where image information for the exposure job concerned is modified to compensate/correspond to the adjusted power. This step (305) will be explained more fully in connection with Figures 4a and 4b.

Alternatively, the calibration/adjustment process itself may take place independently of the exposure process itself, so that a test is not to be performed, but that a state (e.g. exposure and calibration state) is to be selected, where the calibration state influences the exposure state, and one state is accessible from the other.

The modified image information is stored/updated in e.g. a storage, such as a file system, in the RIP, etc., in step (306).

Then the plate/film is exposed on the basis of the modified/updated image information in step (307).

Figures 4a and 4b illustrate alternative embodiments of the method according to the invention for modifying image information.

Figure 4a shows an embodiment (401) of the step (305) shown in Figure 3.

Here a step (403) is performed, where the image information is corrected to correspond to the adjustment of the light intensity. This is done by modifying the image file, e.g. a PS file, in such a manner that any given area in the file to be exposed is diminished precisely by an amount with which the adjusted light intensity will spread the given areas. This can take place particularly advantageously by using a test pattern, as described in connection with Figure 6a.

Hereby, a copy exposed at the corrected light intensity, whereby spot wear is avoided, will have a net spread of essentially zero.

Figure 4a shows an alternative embodiment (401') of the step (305) shown in Figure 3 and comprises the steps (402) and (403). The step (403) corresponds to step (403) described above in connection with Figure 4a.

In step (402) the data file comprising image information is examined, i.e. the file which defines the information to be exposed with a view to replacing/correcting/enlarging all details which are smaller than the spot size concerned/the smallest point which the illumination system can plot. The details must be enlarged to a degree such that they can be plotted by the illumination system, i.e. that they have an extent of the order of the spot size concerned, as smaller details cannot be reproduced anyhow.

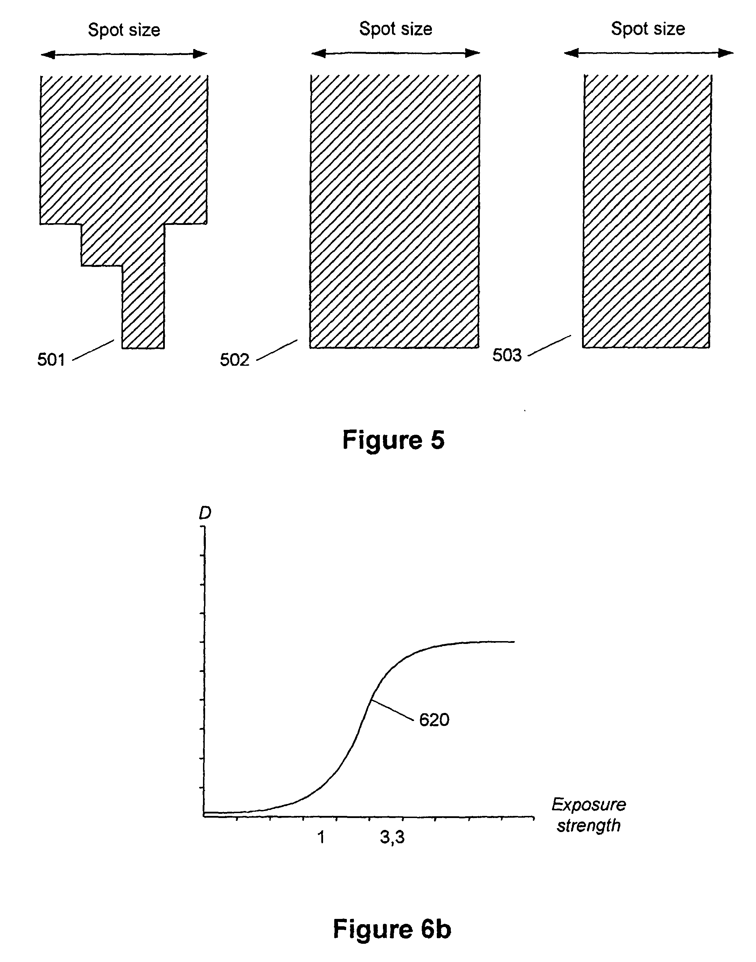

This ensures that the transition point of the photographic medium, i.e. the point where the medium changes from being exposed to being non-exposed or vice versa, coincides with the point where the plotted Gaussian distribution of the light source/laser light has reached 50% of its maximum value. The transition between a given exposed part and a non-exposed part of the medium is thus close to being optimum. This is also outlined in Figure 5.

Figure 5 illustrates the stepwise change of a detail in accordance with an embodiment according to the invention.

Here an exemplary detail section (501) is shown prior to the execution of step (401') shown in Figure 4b.

The section (501) is 5 scan lines wide in this example and contains details which are smaller than a given spot size. An exemplary spot size is likewise indicated and is also 5 scan lines in this example.

The section (502) is the section shown after correction/modification of the image information/data file, where all details have been given an extent of the same order as the spot size. This corresponds to step (402) in Figure 4b.

Then the section (502) is adjusted to compensate for the adjusted light intensity (cf. (step 403) in Figures 4a and 4b), which results in section (503). It will be seen here that the area to be exposed has a smaller extent than the spot size itself, but the corrected light intensity (when adjusted correctly) will spread the exposed area essentially so much that the exposed area has an extent of the same order as the spot size, which means 5 scan lines in this example.

To ensure correctly adjusted light intensity, a suitably selected test pattern is preferably used, as will be explained in connection with Figure 6a.

In this example only the processing of the spreading of the exposed areas in the horizontal direction has been described for clarity, but the spreading will take place radially of course, and therefore a similar processing of the image information with respect to the vertical spreading is also necessary, and may generally be implemented in the same manner as stated above.

Figure 6a shows a corrected test pattern (601) and an uncorrected/ideal test pattern (602), respectively, according to a preferred embodiment of the invention. The test patterns (601, 602) are shown with a number of scan lines (611), where the scan lines are just drawn in the exposed areas.

A current set of test patterns, which may be used particularly expediently/optimally in connection with correct adjustment of power/light intensity of the current light source, depend on a number of factors, including spot size, plate material, resolution.

The corrected test pattern (601) comprises a first part (603) comprising a sequence of non-exposed (605), exposed (606) and non-exposed (607) areas in a vertical direction as well as an associated second part (604) comprising a sequence of exposed (605'), non-exposed (606') and exposed (607') areas in said direction, where the central exposed area (606) associated with the first part (603) has a smaller extent in said direction than the central non-exposed area (606') associated with the second part (604), and where the central non-exposed area (606') associated with the second part (604) is positioned adjacently and symmetrically at the central exposed area (606) associated with the first part (603).

The ideal/uncorrected test pattern (602) comprises a first part (603') comprising a sequence of non-exposed (608), exposed (609) and non-exposed (610) areas in a given direction as well as an adjacent second part (604') comprising a sequence of exposed (608'), non-exposed (609') and exposed (610') areas in said direction, where the central exposed area (609) associated with the first part (603') and the central non-exposed area (609') associated with the second part (604') have the same extent in said direction and are positioned adjacently. The horizontal length of the area (609) (and thereby the area (609')) is essentially equal to the diameter of the spot size of the light source concerned at the optimum level.

The ideal/uncorrected test pattern (602) is the image which should be produced when the test pattern (601) is used as input in the imagesetter/platesetter when the light intensity/power of the light source is optimum, that is minimizes spot wear, that is gives a steep transition between exposed and non-exposed areas.

The optimum adjustment of light intensity/power may then be determined by changing the intensity until the ideal test pattern (602) is produced on a plate. This may be verified e.g. manually through a microscope or the like or automatically, as described before.

The set of test patterns (601, 602) shown in Figure 6a is also called (4:6), which indicates that the number of scan lines (611) in the central exposed area (606) in the first part (603) is 4, and that the number of scan lines in the central non-exposed area (606') associated with the second part (604) is 6 scan lines wide.

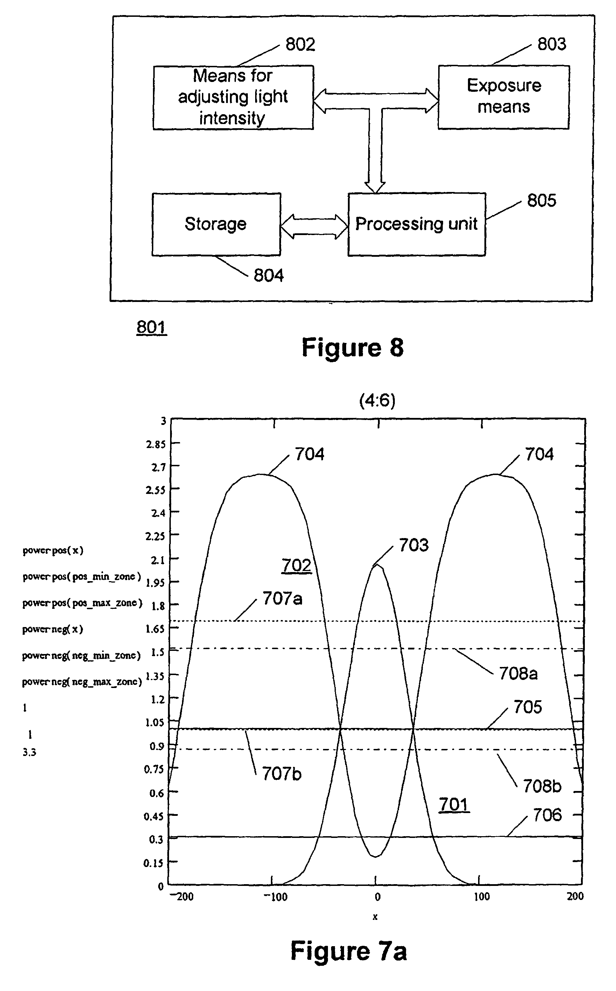

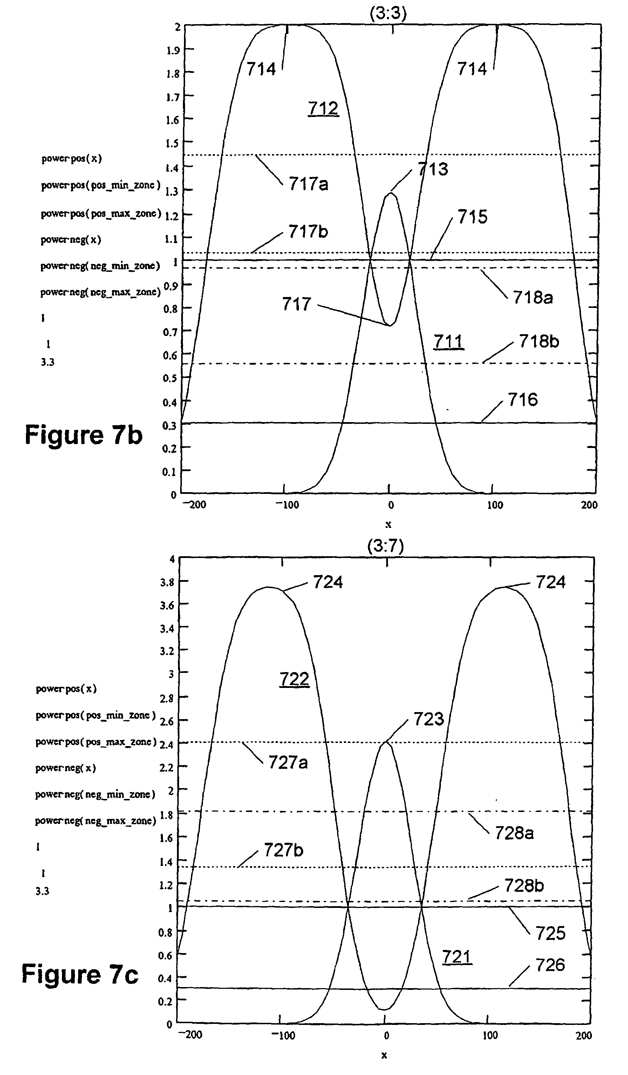

It has been found empirically that, for a preferred embodiment, the specific test patterns (601, 602) (4:6) are particularly expedient for a given plate material out of e.g. (3:7), (3:3), etc. Other test patterns may also be used, but with a consequently less optimal adjustment/setting of light intensity/power precisely for this plate material, these parameters, etc., which will be explained in connection with Figure 7.

For other plate materials, embodiments, the optimum test pattern may be different from (4:6).

Figure 6b illustrates the H-D curve. Shown is a graph (620) known as the Gradation curve or the Hurter-Driffield curve (the H-D curve), which illustrates the relation between exposure strength and density D.

In an embodiment, the light intensity of the density D which defines exposed is substantially 3.3 (rated) times greater than the threshold level of light intensity which defines non-exposed (indicated at 1 in the figure).

Preferred are 3.3 and 1 indicated at the inflexions of the graph (620).

The factor of about 3.3, however, depends on the plate material used for exposure.

The zone between fully exposed and non-exposed is photographically undefinable and should be avoided to the greatest extent possible.

Figures 7a, b and c show examples of how various test patterns may be evaluated.

Figure 7a shows the density (which indicates the degree of exposed ("black/dark") material at a given point) for two scans across a test pattern. This test pattern is a (4:6) test pattern, and is the ideal/uncorrected test pattern (602) shown in Figure 6a.

The two scans have been made at the first part (603') and the second part (604'), respectively, of the test pattern.

The curve (701) shows the density of the first part (603') as a function of a scan horizontally across/along the part (603'). It will be seen that the density is greatest at the centre at the exposed area (609), as indicated at the peak (703).

Correspondingly, the curve (702) shows the density of the second part (604'), where the two peaks (704) are indicated for (608') and (610'), respectively.

Also indicated in the figure are two threshold values (705, 706), where the threshold value (705) indicates the threshold for "dark/exposed" and the value (706) for "light/non-exposed", which indicates that when the density of a given point is above the threshold (705) or below the threshold (706), then the point is designed for dark and light, respectively. The lines (705) and (706) both indicate a transition point, and sometimes the transition point just refers to the line (705). Between the lines, the exposed material is neither completely dark nor completely light. The lines (705) and (706) correspond to the markings for the exposure strength at 3.3 and 1, respectively, in Figure 6b of the H-D curve (620), as the human eye will here perceive the exposed parts as completely dark/black and completely light/white.

Also shown are two intervals indicated at (707a, 707b) and (708a, 708b), respectively. These intervals (707a, 707b); (708a, 708b) indicate when the steepness of (702) and (701) respectively, differs by max. 5% from a given maximum value of the steepness of the curve (702) and the curve (701), respectively. This means that the steepness of the curve (701), within the interval given at (708a) and (708b), differs by max. 5% from the maximum steepness, and correspondingly for the curve (702) and the interval/zone given at (707a) and (707b).

Preferably, the transition point/threshold value given at (705) must be within both of the two zones (707a, 707b) and (708a, 708b), as this ensures an optimal (with max. 5% deviation in this example from the maximum steepness) steepness both for a black line (indicated at 701 and 609) and an inverse/light line (indicated at 702 and 609').

Therefore, the two zones (707a, 707b) and (708a, 708b) must overlap each other for an optimum exposure transition/transition between black and white.

Preferably, the threshold value (705) is 3.3. times greater than the threshold value (706) according to the H-D curve, cf. Figure 6b. The factor 3.3, however, depends on parameters such as e.g. plate material.

The quality of the adjusted power/light intensity may be evaluated by examining the curves (701, 702) e.g. numerically. As mentioned, a criter'ion to be fulfilled for optimum/better adjusted power is that the flank steepness at the threshold values (705, 706) must be as steep as possible, since this gives a much steeper transition between exposed and non-exposed material, which reduces/eliminates the spot wear.

Another/further criterion is that the peaks/maximum densities (703, 704) are as uniform as possible, since the greatest possible uniformity of the exposed pattern is achieved hereby.

Figure 7b shows similar curves for a test pattern (3:3). Also shown here are two graphs (711, 712) of the density of each part of the test pattern. In addition, there are threshold values for dark (715) and light (716), respectively.

Correspondingly, two zones, (717a, 717b) and (718a, 718b) respectively, are indicated for max. 5% deviation of the maximum steepness of the curves (712) and (711), respectively. It will be seen that these zones (717a, 717b); (718a, 718b) do not overlap, and that the transition point (715) is not contained in any of the zones (717a, 717b); (718a, 718b), which means that the flank steepness at the transition point (715) differs by more than 5% from the maximum steepness and will thus not give a sufficiently sharp transition between exposed and non-exposed material, whereby spot wear will occur.

Moreover, the local minimum (717) for the graph (712) does not get below the threshold value (716), which gives an undefinable, obscure or totally lacking white/light/non-exposed colour.

This means that a printing plate exposed with a power/light intensity adjusted on the basis of this test pattern (3:3) will not show well-defined light/non-exposed material at all and will exhibit spot wear because of the softer transition between exposed and non-exposed material.

Figure 7c illustrates similar curves for a test pattern (3:7). Shown here are likewise two graphs (721, 722) of the density of each part of the test pattern. In addition, there are also two threshold values for well-defined dark (725) and light (726), respectively.

Correspondingly, two zones, (727a, 727b) and (728a, 728b) respectively, are indicated for max. 5% deviation of the maximum steepness of the curves (722) and (721), respectively.

For this test pattern it is likewise observed that the transition point is not contained in both zones (727a, 727b) and (728a, 728b), but that well-defined light can be provided, as (722) gets below the threshold value (726).

An optimum test pattern may be determined empirically or numerically in this manner for a given configuration of parameters, such as resolution, spot size, plate material, etc. by comparing/calculating sizes of various curves. It will be seen in this case that (4:6) is the best solution for the given parameters.

Figure 8 shows a schematic block diagram of an embodiment of an apparatus according to the invention.

Shown in the figure is an apparatus (801) which comprises means for adjusting the light intensity/power of a light source (802), exposing means (803) e.g. comprising the light source for exposing photosensitive material, optics, etc. Preferably, the light source is an infrared laser diode.

The means for adjustment (802) may e.g. be simple operating buttons, a graphic user interface, etc. which an operator uses for initiating the adjustment process. The adjustment process may take place both automatically or manually, as described above.

Also shown schematically is a storage (804) which stores image information that represents the material which is to be developed/exposed.

The storage may be any form of standard/known storage, such as e.g. RAM circuits, hard disc(s), etc. as well as combinations thereof.

The apparatus (801) also comprises a processing unit (805), such as e.g. one or more CPUs as well as optional other dedicated processors. The processing unit (805) controls, coordinates the other means and make calculations, if any, on the image information in the storage (804). Image information is typically provided in the storage (804) from a RIP via a I/O interface (not shown), such as a network card/gate or the like.

The figure just comprises details which are relevant to the invention, and not details which are standard in connection with known imagesetters/platesetters, such as e.g. means for introducing and discharging material, feeding means (transporting material for exposure around in the apparatus itself), communications means (for exchange of data with other devices/systems such as e.g. a I/O unit), etc.

## Claims

1. A method of controlling light intensity in connection with the exposure of photosensitive material in an image-setter/platesetter comprising a light source for illuminating said photosensitive material, **characterized by**
• increasing the light intensity of said light source to a predetermined level ensuring a sufficiently steep transition between exposed and non-exposed material, and
• modifying image information representing material for exposure so as to reduce the time during which the light source is active.

2. A method according to claim 1, **characterized in that** said adjustment of said light intensity is provided by
• selecting an ideal test pattern and an associated corrected test pattern,
• storing image information representing the corrected test pattern, and
• adjusting the light intensity so that exposure of the corrected test pattern provides an image of the ideal uncorrected test pattern.

3. A method according to claim 2, **characterized in that** said adjustment is provided automatically.

4. A method according to claim 2 or 3, **characterized in that** said ideal test pattern comprises a first part comprising a sequence of non-exposed, exposed and non-exposed areas in a given direction as well as an adjacent second part comprising a sequence of exposed, non-exposed and exposed areas in said direction, wherein the central exposed area associated with the first part and the central non-exposed area associated with the second part have the same extent in said direction and are positioned adjacently.

5. A method according to claims 2 - 4, **characterized in that** said corrected test pattern comprises a first part comprising a sequence of non-exposed, exposed and non-exposed areas in one direction as well as an adjacent second part comprising a sequence of exposed, non-exposed and exposed areas in said direction, wherein the central exposed area associated with the first part has a smaller extent in said direction than the central non-exposed area associated with the second part, and wherein the central non-exposed area associated with the second part is positioned adjacently and symmetrically at the central exposed area associated with the first part.

6. A method according to claims 4 - 5, **characterized in that** the exposed area associated with the sequence of the first part of said corrected test pattern is 4 scan lines wide, and that the non-exposed area associated with the sequence of the second part of said corrected test pattern is 6 scan lines wide.

7. A method according to claims 4 - 6, **characterized in that** the flank steepnesses of the light intensity at the transitions of the first part and the second part, respectively, are maximum at the threshold value of the photographic medium for exposed/non-exposed.

8. A method according to claims 1 - 7, **characterized in that** said modification of image information comprises a change in the data file which defines an original prior to the further processing of it.

9. A method according to claim 8, **characterized in that** said modification comprises a modification so that all information in the data file at least has a spread of the same extent as the spot size of said light source.

10. An apparatus for controlling light intensity in connection with the exposure of photosensitive material in an imagesetter/platesetter, comprising
• a light source for illuminating said photosensitive material,
**characterized in that** the apparatus additionally comprises
• adjustment means for adjusting the light intensity so that the light intensity of said light source may be increased to a predetermined level ensuring a steep transition between exposed and non-exposed material,
• a storage comprising image information representing material for exposure, and
• a processing unit modifying the image information so as to reduce the time during which the light source is active.

11. An apparatus according to claim 10, **characterized in that** said adjustment of said light intensity is provided **in that**
• an ideal test pattern and an associated corrected test pattern are selected,
• image information representing the corrected test pattern is stored, and
• the light intensity is adjusted so that exposure of the corrected test pattern provides an image of the ideal uncorrected test pattern.

12. An apparatus according to claim 11, **characterized in that** said adjustment is provided automatically.

13. An apparatus according to claim 12 **characterized in that** said ideal test pattern comprises a first part comprising a sequence of non-exposed, exposed and non-exposed areas in a given direction as well as an adjacent second part comprising a sequence of exposed, non-exposed and exposed areas in said direction, wherein the central exposed area associated with the first part and the central non-exposed area associated with the second part have the same extent in said direction and are positioned adjacently.

14. An apparatus according to claims 11 - 13, **characterized in that** said corrected test pattern comprises a first part comprising a sequence of non-exposed, exposed and non-exposed areas in one direction as well as an adjacent second part comprising a sequence of exposed, non-exposed and exposed areas in said direction, wherein the central exposed area associated with the first part has a smaller extent in said direction than the central non-exposed area associated with the second part, and wherein the central non-exposed area associated with the second part is positioned adjacently and symmetrically at the central exposed area associated with the first part.

15. An apparatus according to claims 13 - 14, **characterized in that** the exposed area associated with the sequence of the first part of said corrected test pattern is 4 scan lines wide, and that the non-exposed area associated with the sequence of the second part of said corrected test pattern is 6 scan lines wide.

16. An apparatus according to claims 13 - 15, **characterized in that** the flank steepnesses of the light intensity at the transitions of the first part and of the second part, respectively, are maximum at the threshold value of the photographic medium for exposed/non-exposed.

17. An apparatus according to claims 10 - 16, **characterized in that** said modification of image information comprises a change in the data file which defines an original prior to the further processing of it.

18. An apparatus according to claim 17, **characterized in that** said modification comprises a modification so that all information in the data file at least has a spread of the same extent as the spot size of said light source.

## Patentansprüche

1. Verfahren zur Steuerung der Lichtintensität in Verbindung mit der Belichtung von lichtempfindlichem Material in einem Bild-/Druckplatten-Belichter mit einer Lichtquelle zur Beleuchtung des lichtempfindlichen Materials, **gekennzeichnet durch**:
· Vergrößern der Lichtintensität der Lichtquelle auf einem vorgegebenen Pegel, der einen ausreichend steilen Übergang zwischen belichtetem und nicht belichtetem Material ergibt; und
· Modifizieren der Bildinformation, die Material für die Belichtung darstellt, derart, dass die Zeit, während der die Lichtquelle aktiv ist, verringert wird.

2. Verfahren nach Anspruch 1, **dadurch gekennzeichnet, dass** die Einstellung der Lichtintensität dadurch geschaffen wird, dass:
· ein ideales Testmuster und ein zugehöriges korrigiertes Testmuster ausgewählt wird,
· Bildinformation, die das korrigierte Testmuster darstellt, gespeichert wird, und
· die Lichtintensität derart eingestellt wird, dass die Belichtung des korrigierten Testmusters ein Bild des idealen nicht korrigierten Testmusters liefert.

3. Verfahren nach Anspruch 2, **dadurch gekennzeichnet, dass** die Einstellung automatisch durchgeführt wird.

4. Verfahren nach Anspruch 2 oder 3, **dadurch gekennzeichnet, dass** das ideale Testmuster einen ersten Teil, der eine Folge von nicht belichteten, belichteten und nicht belichteten Bereichen in einer vorgegebenen Richtung umfasst, sowie einen benachbarten zweiten Teil umfasst, der eine Folge von belichteten, nicht belichteten und belichteten Bereichen in der genannten Richtung umfasst, wobei der in der Mitte liegende belichtete Bereich, der dem ersten Teil zugeordnet ist, und der in der Mitte liegende nicht belichtete Bereich, der dem zweiten Teil zugeordnet ist, die gleiche Erstreckung in der genannten Richtung haben und benachbart angeordnet sind.

5. Verfahren nach den Ansprüchen 2-4, **dadurch gekennzeichnet, dass** das korrigierte Testmuster einen ersten Teil, der eine Folge von nicht belichteten, belichteten und nicht belichteten Bereichen in einer Richtung umfasst, sowie einen benachbarten zweiten Teil umfasst, der eine Folge von belichteten, nicht belichteten und belichteten Bereichen in der genannten Richtung umfasst, wobei der in der Mitte liegende belichtete Bereich, der dem ersten Teil zugeordnet ist, eine kleinere Erstreckung in der genannten Richtung aufweist, als der in der Mitte liegende nicht belichtete Bereich, der dem zweiten Teil zugeordnet ist, und wobei der in der Mitte liegende nicht belichtete Bereich, der dem zweiten Teil zugeordnet ist, benachbart und symmetrisch an dem in der Mitte liegenden belichteten Bereich angeordnet ist, der dem ersten Teil zugeordnet ist.

6. Verfahren nach den Ansprüchen 4-5, **dadurch gekennzeichnet, dass** der belichtete Bereich, der der Folge des ersten Teils des korrigierten Testmusters zugeordnet ist, vier Abtastzeilen breit ist, und dass der nicht belichtete Bereich, der der Folge des zweiten Teils des korrigierten Testmusters zugeordnet ist, sechs Abtastzeilen breit ist.

7. Verfahren nach den Ansprüchen 4-6, **dadurch gekennzeichnet, dass** die Flankensteilheit der Lichtintensität an den Übergängen des ersten Teils bzw. des zweiten Teils ein Maximum an dem Schwellenwert des fotografischen Mediums für den belichteten/nicht belichteten Zustand aufweist.

8. Verfahren nach den Ansprüchen 1-7, **dadurch gekennzeichnet, dass** die Modifikation der Bildinformation eine Änderung in der ein Original definierenden Datendatei vor deren Weiterverarbeitung umfasst.

9. Verfahren nach Anspruch 8, **dadurch gekennzeichnet, dass** die Modifikation eine Modifikation derart umfasst, dass alle Information in der Datendatei zumindest eine Breite in dem gleichen Ausmaß wie die Punktgröße der Lichtquelle hat.

10. Vorrichtung zur Steuerung der Lichtintensität in Verbindung mit der Belichtung von lichtempfindlichem Material in einem Bild-/Druckplatten-Belichter, mit:
· einer Lichtquelle zur Beleuchtung des lichtempfindlichen Materials,
**dadurch gekennzeichnet, dass** die Vorrichtung zusätzlich folgendes umfasst:
· Einstelleinrichtungen zur Einstellung der Lichtintensität derart, dass die Lichtintensität der Lichtquelle auf einen vorgegebenen Pegel vergrößert werden kann, der einen steilen Übergang zwischen belichtetem und nicht belichtetem Material sicherstellt,
· einen Speicher, der Bildinformation enthält, das Material zur Belichtung darstellt, und
· eine Verarbeitungseinheit, die die Bildinformation derart modifiziert, dass die Zeit verringert wird, während der die Lichtquelle aktiv ist.

11. Vorrichtung nach Anspruch 10, **dadurch gekennzeichnet, dass** die Einstellung der Lichtintensität derart vorgesehen ist, dass:
· ein ideales Testmuster und ein zugehöriges korrigiertes Testmuster ausgewählt wird,
· Bildinformation, die das korrigierte Testmuster darstellt, gespeichert wird, und
· die Lichtintensität derart eingestellt wird, dass die Belichtung des korrigierten Testmusters ein Bild des idealen unkorrigierten Testmusters ergibt.

12. Vorrichtung nach Anspruch 11, **dadurch gekennzeichnet, dass** die Einstellung automatisch vorgesehen ist.

13. Vorrichtung nach Anspruch 12, **dadurch gekennzeichnet, dass** das ideale Testmuster einen ersten Teil, der eine Folge von nicht belichteten, belichteten und nicht belichteten Bereichen in einer vorgegebenen Richtung umfasst, sowie einen benachbarten zweiten Teil umfasst, der eine Folge von belichteten, nicht belichteten und belichteten Bereichen in der genannten Richtung umfasst, wobei der in der Mitte liegende belichtete Bereich, der dem ersten Teil zugeordnet ist, und der in der Mitte liegende nicht belichtete Bereich, der dem zweiten Teil zugeordnet ist, die gleiche Erstreckung in der genannten Richtung haben und benachbart angeordnet sind.

14. Vorrichtung nach den Ansprüchen 11-13, **dadurch gekennzeichnet, dass** das korrigierte Testmuster einen ersten Teil, der eine Folge von nicht belichteten, belichteten und nicht belichteten Bereichen in einer Richtung umfasst, sowie einen benachbarten zweiten Teil umfasst, der eine Folge von belichteten, nicht belichteten und belichteten Bereichen in der genannten Richtung umfasst, wobei der in der Mitte liegende belichtete Bereich, der dem ersten Teil zugeordnet ist, eine kleinere Erstreckung in der genannten Richtung aufweist, als der in der Mitte liegende nicht belichtete Bereich, der dem zweiten Teil zugeordnet ist, und wobei der in der Mitte liegende nicht belichtete Bereich, der dem zweiten Teil zugeordnet ist, benachbart und symmetrisch an dem in der Mitte liegenden belichteten Teil angeordnet ist, der dem ersten Teil zugeordnet ist.

15. Vorrichtung nach den Ansprüchen 13-14, **dadurch gekennzeichnet, dass** der belichtete Bereich, der der Folge des ersten Teils des korrigierten Testmusters zugeordnet ist, vier Abtastzeilen breit ist, und dass der nicht belichtete Bereich, der der Folge des zweiten Teils des korrigierten Testmusters zugeordnet ist, sechs Abtastzeilen breit ist.

16. Vorrichtung nach den Ansprüchen 13-15, **dadurch gekennzeichnet, dass** die Flankensteilheiten der Lichtintensität an den Übergängen des ersten Teils bzw. des zweiten Teils ein Maximum an dem Schwellenwert des fotografischen Mediums für den belichteten/nicht belichteten Zustand aufweisen.

17. Vorrichtung nach den Ansprüchen 10-16, **dadurch gekennzeichnet, dass** die Modifikation der Bildinformation eine Änderung der ein Original definierenden Datendatei vor der weiteren Verarbeitung hiervon umfasst.

18. Vorrichtung nach Anspruch 17, **dadurch gekennzeichnet, dass** die Modifikation eine Modifikation derart umfasst, dass alle Information in der Datendatei zumindest eine Breite mit dem gleichen Ausmaß aufweist, wie die Punktgröße der Lichtquelle.

## Revendications

1. Procédé de commande de l'intensité lumineuse en rapport avec l'exposition d'un matériau photosensible dans une imageuse de film/imageuse de plaque, comprenant une source lumineuse pour éclairer ledit matériau photosensible, **caractérisé par**
• l'augmentation de l'intensité lumineuse de ladite source lumineuse à un niveau prédéterminé, assurant une transition suffisamment nette entre le matériau exposé et non exposé et
• la modification de l'information sur l'image, qui représente le matériau de base pour l'exposition, de façon à réduire le temps, durant lequel la source lumineuse est active.

2. Procédé selon la revendication 1, **caractérisé en ce que** ledit ajustement de ladite intensité lumineuse est assuré par
• la sélection d'une séquence d'essai idéal et d'une séquence d'essai corrigée associée,
• la mémorisation de l'information sur l'image, qui représente la séquence d'essai corrigée et
• l'ajustement de l'intensité lumineuse, de sorte que l'exposition de la séquence d'essai corrigée fournisse une image de la séquence d'essai non corrigée idéale.

3. Procédé selon la revendication 2, **caractérisé en ce que** ledit ajustement est assuré automatiquement.

4. Procédé selon la revendication 2 ou 3, **caractérisé en ce que** ladite séquence d'essai idéale comprend une première partie, comprenant une suite de zones non exposées, exposées et non exposées dans une direction donnée, de même qu'une deuxième partie adjacente, comprenant une suite de zones exposées, non exposées et exposées dans ladite direction, dans lequel la zone exposée centrale, associée à la première partie et la zone non exposée centrale, associée à la deuxième partie, ont la même étendue dans ladite direction et sont positionnées de manière adjacente.

5. Procédé selon les revendications 2 à 4, **caractérisé en ce que** ladite séquence d'essai corrigée comprend une première partie, comprenant une suite de zones non exposées, exposées et non exposées dans une direction, de même qu'une deuxième partie adjacente, comprenant une suite de zones exposées, non exposées et exposées dans ladite direction, dans lequel la zone exposée centrale, associée à la première partie, présente une étendue plus petite dans ladite direction que la zone non exposée centrale, associée à la deuxième partie et dans lequel la zone non exposée centrale, associée à la deuxième partie, est positionnée de manière adjacente à et symétrique par rapport à la zone exposée centrale, associée à la première partie.

6. Procédé selon les revendications 4 et 5, **caractérisé en ce que** la zone exposée, associée à la suite de la première de ladite séquence d'essai corrigée, fait 4 lignes de balayage de large et que la zone non exposée, associée à la suite de la deuxième partie de ladite séquence d'essai corrigée, fait 6 lignes de balayage de large.

7. Procédé selon les revendications 4 à 6, **caractérisé en ce que** les pentes du flanc de l'intensité lumineuse, aux transitions de la première partie et de la deuxième partie, respectivement, sont maximales à la valeur de seuil du support photographique pour exposé/non exposé.

8. Procédé selon les revendications 1 à 7, **caractérisé en ce que** ladite modification de l'information sur l'image comprend un changement dans le fichier de données, qui définit un original, préalable à la suite de son traitement.

9. Procédé selon la revendication 8, **caractérisé en ce que** ladite modification comprend une modification, de sorte que toutes les informations, contenues dans le fichier de données, possèdent au moins une ampleur de la même étendue que la dimension de point de ladite source lumineuse.

10. Dispositif de commande de l'intensité lumineuse en rapport avec l'exposition d'un matériau photosensible dans une imageuse de film/imageuse de plaque, comprenant
• une source lumineuse, pour éclairer ledit matériau photosensible,
**caractérisé en ce que** le dispositif comprend de plus
• un moyen d'ajustement pour ajuster l'intensité lumineuse, de sorte que l'intensité lumineuse de ladite source lumineuse puisse être augmentée pour atteindre un niveau prédéterminé, qui assure une transition nette entre le matériau exposé et non exposé,
• une mémorisation, comprenant l'information sur l'image, qui représente le matériau de base pour l'exposition et
• une unité de traitement, qui modifie l'information sur l'image, de façon à réduire le temps, durant lequel la source lumineuse est active.

11. Dispositif selon la revendication 10, **caractérisé en ce que** ledit ajustement de ladite intensité lumineuse est prévu **en ce**
• **qu'**une séquence d'essai idéale et une séquence d'essai corrigée associée sont sélectionnées,
• que l'information sur l'image, qui représente la séquence d'essai corrigée, est mémorisée et
• que l'intensité lumineuse est ajustée, de sorte que l'exposition de la séquence d'essai corrigée fournit une image de la séquence d'essai non corrigée idéale.

12. Dispositif selon la revendication 11, **caractérisé en ce que** ledit ajustement est assuré automatiquement.

13. Dispositif selon la revendication 12, **caractérisé en ce que** ladite séquence d'essai idéale comprend une première partie, comprenant une suite de zones non exposées, exposées et non exposées dans une direction donnée, de même qu'une deuxième partie adjacente, comprenant une suite de zones exposées, non exposées et exposées dans ladite direction, dans lequel la zone exposée centrale, associée à la première partie et la zone non exposée centrale, associée à la deuxième partie, ont la même étendue dans ladite direction et sont positionnées de manière adjacente.

14. Dispositif selon les revendications 11 à 13, **caractérisé en ce que** ladite séquence d'essai corrigée comprend une première partie, comprenant une suite de zones non exposées, exposées et non exposées dans une direction, de même qu'une deuxième partie adjacente, comprenant une suite de zones exposées, non exposées et exposées dans ladite direction, dans lequel la zone exposée centrale, associée à la première partie, a une étendue plus petite dans ladite direction que la zone non exposée centrale, associée à la deuxième partie et dans lequel la zone non exposée centrale, associée à la deuxième partie est positionnée de manière adjacente à et symétrique par rapport à la zone exposée centrale, associée à la première partie.

15. Dispositif selon les revendications 13 et 14, **caractérisé en ce que** la zone exposée, associée à la suite de la première partie de ladite séquence d'essai corrigée fait 4 lignes de balayage de large et que la zone non exposée, associée à la suite de la deuxième partie de ladite séquence d'essai corrigée fait 6 lignes de balayage de large.

16. Dispositif selon les revendications 13 à 15, **caractérisé en ce que** les pentes du flanc de l'intensité lumineuse, aux transitions de la première et de la deuxième partie, respectivement, sont maximales à la valeur de seuil du support photographique pour exposé/non exposé.

17. Dispositif selon les revendications 10 à 16, **caractérisé en ce que** ladite modification de l'information sur l'image comprend un changement dans le fichier de données, qui définit un original, préalable à la suite de son traitement.

18. Dispositif selon la revendication 17, **caractérisé en ce que** ladite modification comprend une modification, de sorte que toutes les informations, contenues dans le fichier de données, possèdent au moins une ampleur de la même étendue que la dimension de point de ladite source lumineuse.
